# EUROPEAN PATENT APPLICATION

(11) **EP 3 945 327 A1**
(43) Date of publication of application: **02.02.2022**
(21) Application number: 20203076.3
(22) Date of filing: 21.10.2020
(51) Int. Cl.: G01R 31/317, G01R 1/07

(54) **HYBRID AUTOMATED TESTING EQUIPMENT FOR TESTING OF OPTICAL-ELECTRICAL DEVICES**

(30) Priority: 31.07.2020 US 202016945299
(71) Applicant: Juniper Networks, Inc., Sunnyvale, CA 94089 (US)
(72) Inventor: MYSLINSKI, Piotr, Sunnyvale, CA 94089 (US); BARNARD, Chris, Sunnyvale, CA 94089 (US); KECK, Steven William, Sunnyvale, CA 94089 (US); MARCOCCIA, Roberto, Sunnyvale, CA 94089 (US); SCHMIDT, Theodore J., Sunnyvale, CA 94089 (US)
(74) Representative: D Young & Co LLP

(57) **Abstract**

A hybrid optical-electrical automated testing equipment (ATE) system can implement an optical test assembly that includes an electrical interface and an optical interface with an optical-electrical device under test. The optical assembly can include a socket on which the device is placed by the ATE system to connect electrical and optical connections. The optical connections can couple light through the socket and the optical assembly to one or more testing devices to perform efficient testing of optical devices, such as high-speed optical transceivers.

## Description

### TECHNICAL FIELD

The present disclosure generally relates to optical circuits and more particularly to testing optical-electrical devices.

### BACKGROUND

Modern high-speed integrated circuits (ICs) have complex architectures, with millions of components such as transistors that must operate in concert to transmit data at multi-gigabit data rates required by modern communication networks. One of the critical steps of manufacturing such devices is the testing and calibration of the high-speed devices to ensure the devices do not fail at a later point in time (after integration into a product). One issue with testing and calibration of such high-speed devices stems from the modern design process, in which different components of the device are designed by different companies as "off the shelf" components. To this end, an automated test equipment (ATE) can be implemented by the device engineers to efficiently test high-speed designs at the chip and wafer level. Generally, an ATE system includes one or more computer-controlled equipment or modules that interface with the device under test (DUT) to perform stress testing and analyze individual components with minimal human interaction. Current ATE systems that are configured for electronic or semiconductor devices are not configured to provide rapid testing and calibration of some modern hybrid high-speed devices, such as optical transceivers that process both electricity and light to achieve higher data rates.

### BRIEF DESCRIPTION OF THE DRAWINGS

The following description includes discussion of figures having illustrations given by way of example of implementations of embodiments of the disclosure. The drawings should be understood by way of example, and not by way of limitation. As used herein, references to one or more "embodiments" are to be understood as describing a particular feature, structure, or characteristic included in at least one implementation of the inventive subject matter. Thus, phrases such as "in one embodiment" or "in an alternate embodiment" appearing herein describe various embodiments and implementations of the inventive subject matter, and do not necessarily all refer to the same embodiment. However, they are also not necessarily mutually exclusive. To easily identify the discussion of any particular element or act, the most significant digit or digits in a reference number refer to the figure ("FIG.") number in which that element or act is first introduced.
FIG. 1 shows an optical and electrical testing system for implementing simultaneous optical and electrical testing of photonic devices, according to some example embodiments.
FIG. 2 is a block diagram illustrating an optical transceiver for transmitting and receiving optical signals, according to some example embodiments.
FIG. 3 displays an optical-electrical ATE interconnection architecture, according to some example embodiments.
FIG. 4 shows optical testing devices that can interface with the optical electrical DUT using optical connections, according to some example embodiments.
FIG. 5A shows an optical socket interface architecture, according to some example embodiments.
FIG. 5B shows port architecture for the socket-side optical connection, according to some example embodiments.
FIG. 6A shows a mount-based optical interface architecture, according to some example embodiments.
FIG. 6B shows a detailed view of the optical interface architecture, according to some example embodiments.
FIG. 7A shows a mount and socket based optical interface architecture, according to some example embodiments.
FIG. 7B shows side socket based optical interface architecture, according to some example embodiments.
FIG. 8 is a flow diagram of a method for optical-electrical testing, according to some example embodiments.
FIG. 9 is an illustration of an optical-electrical device, according to some example embodiments.

Descriptions of certain details and implementations follow, including a description of the figures, which may depict some or all of the embodiments described below, as well as discussing other potential embodiments or implementations of the inventive concepts presented herein. An overview of embodiments of the disclosure is provided below, followed by a more detailed description with reference to the drawings.

### DETAILED DESCRIPTION

The invention is defined in the claims. In the following description, for the purposes of explanation, numerous specific details are set forth in order to provide an understanding of various embodiments of the inventive subject matter. It will be evident, however, to those skilled in the art, that embodiments of the inventive subject matter may be practiced without these specific details. In general, well-known instruction instances, structures, and techniques are not necessarily shown in detail.

Modern ATE systems are not configured to rapidly test, validate, and calibrate modern hybrid high-speed devices, such as optical transceivers, which include both complex electrical and optical modules. To this end, a hybrid optical-electrical ATE system can be implemented that uses one or more electrical interfaces to interface with electrical apparatuses of the ATE system and one or more optical interfaces (e.g., fibers, lens, gratings) to interface with optical components of the ATE system. In some example embodiments, the hybrid optical-electrical ATE system is implemented by augmenting an electrical ATE system (e.g., an available off-the-shelf electrical ATE system) with an optical assembly to create an optical interface between the optical-electrical DUT and the ATE system. In some example embodiments, the optical assembly comprises a high-speed electrical socket and a docking plate that include electrical and optical ports to DUT. The optical ports to the DUT can be integrated into the socket, the docking plate, or both the socket and the docking plate. In some example embodiments, a mount of the ATE system can attach to the DUT and place the DUT on the socket, which supports the DUT during simultaneous optical-electrical testing and calibration.

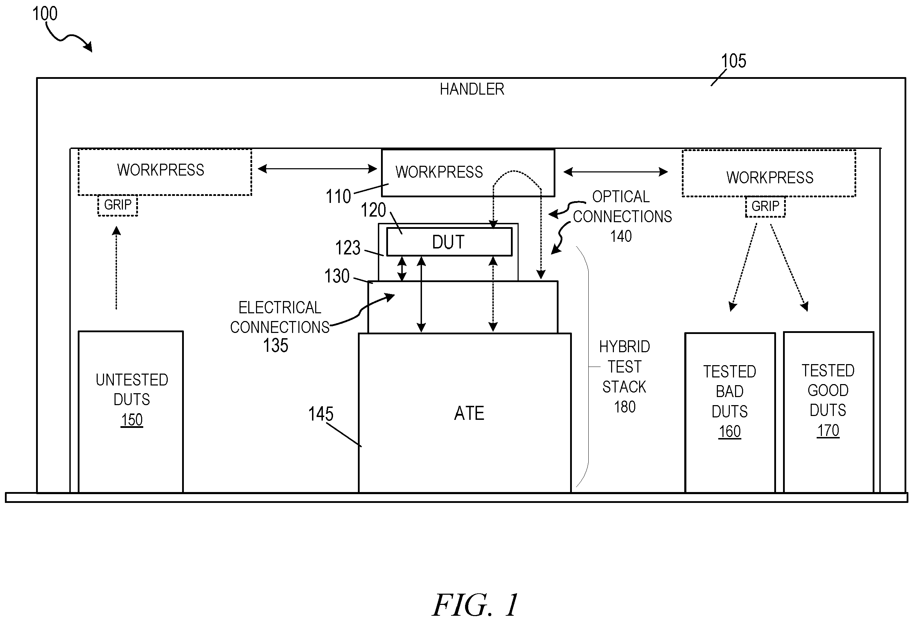

FIG. 1 shows an optical and electrical testing system 100 for implementing simultaneous optical and electrical testing of photonic devices, according to some example embodiments. As illustrated, a handler 105 (e.g., IC handler, chip hander) is a robotic system that can precisely move a DUT 120 into position for testing and calibration using an actuating mount including a workpress assembly and mount (plastic mount). The workpress assembly 110 is attached to the handler 105 to move the DUT 120 to a test socket 123. The test socket 123 is further positioned on an optical test assembly 130 (e.g., a customized docking plate), which provides an optical interface for optical testing of the DUT 120 using one or more optical devices modules (e.g., an optical spectrum analyzer) and an ATE 145, which provides electrical automated testing using one or more electrical analyzer modules. The DUT 120 is electrically connected via electrical connections 135 (e.g., high-speed test socket 123) to the optical test assembly 130 and the ATE 145. Furthermore, the DUT 120 can interface optically with the optical test assembly 130 using one or more optical connections 140 (depicted as dotted arrows) that can extend through the socket 123, the docking plate, and the workpress assembly 110, according to some example embodiments.

In some example embodiments, the handler 105 moves the workpress assembly 110 to pick up the DUT 120 from an untested device stack 150 (e.g., staging area or tray holding DUTs to undergo hybrid testing), and moves the DUT 120 to socket 123 of a hybrid test stack 180. The socket 123 can have electrical connections (e.g., pins, pads, traces) that align with electrical connections on the DUT 120 to electrically couple the DUT 120 to the optical test assembly 130. The optical test assembly 130 can be implemented as a docking plate having integrated electrical interfaces to one or more electrical testing modules (e.g., line cards, modules) of the ATE 145. In placing the DUT 120 on the socket 123, the electrical testing modules can send and receive electrical signals to the DUT 120 via the optical test assembly 130 and the socket 123.

The optical connections 140 provide an optical interface between optical testing devices for testing and calibration of the optical components of the DUT 120 (e.g., optical modulators, heaters, embedded lasers). In some example embodiments, an optical port of the DUT 120 (e.g., a grating, an optical waveguide) is optically coupled to another optical port integrated in the optical test assembly (e.g., another grating, an optical waveguide, a fiber in the optical test assembly 130). The optical ports can be aligned using one or more sets of physical alignment features, as discussed in further detail below. Once aligned, the electrical testing devices of the ATE 145 can test and calibrate electrical components of the DUT 120 while optical test devices of the ATE 145 can simultaneously test and calibrate optical components of the DUT 120. In some example embodiments, after testing and calibration by the hybrid test stack 180, the handler 105 attaches to the DUT 120 and moves the DUT 120 to a tested good stack 170 or tested bad device stack 160 depending on the results of the hybrid testing and calibration.

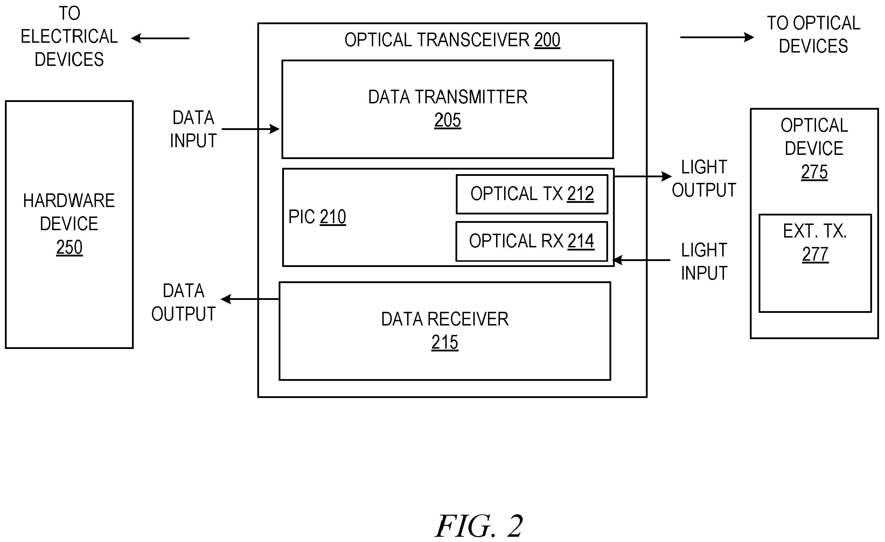

FIG. 2 is a block diagram illustrating an optical transceiver 200 for transmitting and receiving optical signals, according to some example embodiments. The optical transceiver 200 is an example optical-electrical DUT (e.g., DUT 120) that can be tested using the optical and electrical testing system 100 of FIG.1. In the example illustrated in FIG. 2, the optical transceiver 200 processes data from electrical devices, such as electrical hardware device 250, converts the electrical data into optical data, and sends and receives the optical data with one or more optical devices,. For example, the electrical hardware device 250 can be a host board that "hosts" the optical transceiver 200 as a pluggable device that sends and receives data to an optical switch network; where, for example, optical device 275 can be other components of an optical switch network (e.g., external transmitter 277). However, it is appreciated that the optical transceiver 200 can be implemented to interface with other types of electrical devices and optical devices. For instance, the optical transceiver 200 can be implemented as a single chip on a hybrid "motherboard" that uses an optical network (e.g., waveguides, fibers, free space optics) as an optical bus to interconnect on-board electrical chips that process the data after it is converted from light into binary electrical data, according to some example embodiments. As an additional example, example optical device 275 can be implemented to receive and analyze signals from the PIC transmitter and/or calibrate the PIC transmitter 212 and transmit an external optical signal to the PIC receiver 214 to test and/or calibrate the PIC receiver 214, according to some example embodiments.

In some example embodiments, the hardware device 250 includes an electrical interface for receiving and mating with an electrical interface of the optical transceiver 200. The optical transceiver 200 may be a removable front-end module that may be physically received by and removed from hardware device 250 operating as a backend module within a communication system or device. The optical transceiver 200 and the hardware device 250, for example, can be components of an optical communication device or system (e.g., a network device) such as a wavelength-division multiplexing (WDM) system or a parallel fiber system (e.g., parallel-single fiber (PSM)), according to some example embodiments.

A data transmitter 205 of the optical transceiver 200 can receive the electrical signals, which are then converted into optical signals via photonic integrated circuit (PIC) 210. The PIC 210 can then output the optical signals via optical links, such as fibers, waveguides or free space optics that interface with the PIC 210. The output light data can then be processed by other components (e.g., switches, endpoint servers, other embedded chips of on a single embedded system), via a network such as a wide area network (WAN), optical switch network, optical waveguide network in an embedded system, and others.

In receiver mode, the optical transceiver 200 can receive high data rate optical signals via one or more optical links from optical device 275. The optical signals are converted by the PIC 210 from light into electrical signals for further processing by data receiver 215, such as demodulating the data into a lower data rate for output to other devices, such as the electrical hardware device 250. The modulation used by the optical transceiver 200 can include pulse amplitude modulation (e.g., 4-level PAM, such as "PAM4"), quadrature phase-shift keying (QPSK), binary phase-shift keying (BPSK), polarization-multiplexed BPSK, M-ary quadrature amplitude modulation (M-QAM), and others.

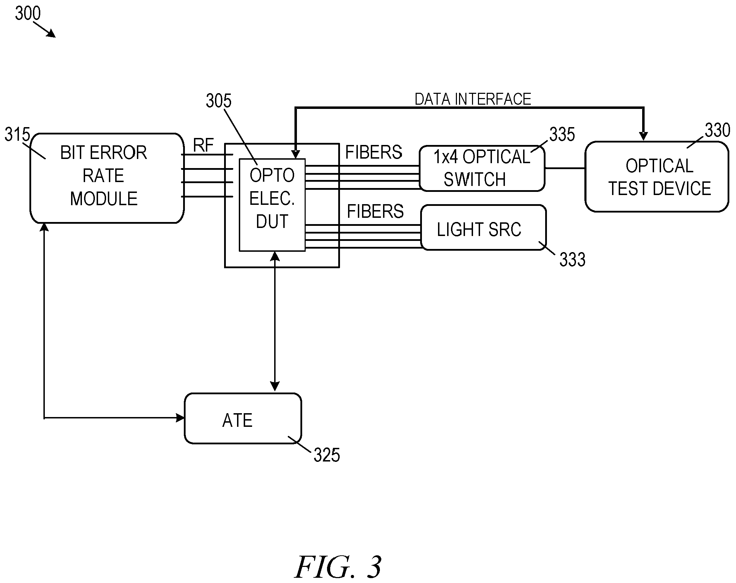

FIG. 3 displays an optical-electrical ATE interconnection architecture 300, according to some example embodiments. At a high level, an ATE 325 interfaces with an optical-electrical DUT 305 (e.g., DUT 120) and a bit error rate module 315 (e.g., an embedded bit error rate tester), according to some example embodiments. The DUT 305 can include a microprocessor storing calibration instructions (e.g., firmware) to initiate and perform self-testing. For example, the microprocessor can interface with an optical test device 330 (e.g., compact optical spectrum analyzer (OSA)) using a data interface (e.g., RS-232), and optically via one or more fibers and an optical switch 335. In some example embodiments, the DUT 305 receives light from one or more fibers coupled to a light source 333, which couples light into the receive port of the DUT 305. The DUT 305 receives the light and generates modulated light using one or more modulators. The fibers extending from the light source 333 to the DUT 305 and the fibers extending from the DUT 305 to the optical switch 335 can be implemented as the optical connections 140 (FIG. 1). In some example embodiments, the optical switch 335 is operable to select one of the available plurality of fibers for output to the optical test device 330. The DUT 305 is electrically coupled to the optical switch 335 to select which fiber is active and coupled to the optical test device 330. In some example embodiments, the DUT 305 can read and store values from the optical test device 330 or bit error rate module 315 in local memory for later calibration. The DUT 305 can further control a closed loop airflow to control the DUT temperature during the calibration process to ensure accuracy. In some example embodiments, DUT 305 configures itself in a loopback mode in which the DUT transmitter transmits to the DUT receiver along a loopback path (e.g., integrated waveguide). While in loopback mode, the bit error rate module 315 can perform further testing of the DUT 305. In some example embodiments, the DUT 305 does not include calibration instructions or firmware and instead the DUT is calibrated via external control by the ATE 325 or an external computer connected to the ATE 325. Further details of hybrid testing and calibration operations are discussed in Application Serial No. 16/907857, titled "Optical Transceiver Loopback Eye Scans," filed on June 22, 2020; Application Serial No. 16/887668, titled "Optical-Electrical Device Testing Using Hybrid Automated Testing Equipment", filed on May 29, 2020; and Application titled "Multi-Lane Optical-Electrical Device Testing Using Automated Testing Equipment," filed on even date herewith, which are incorporated by reference in their entirety.

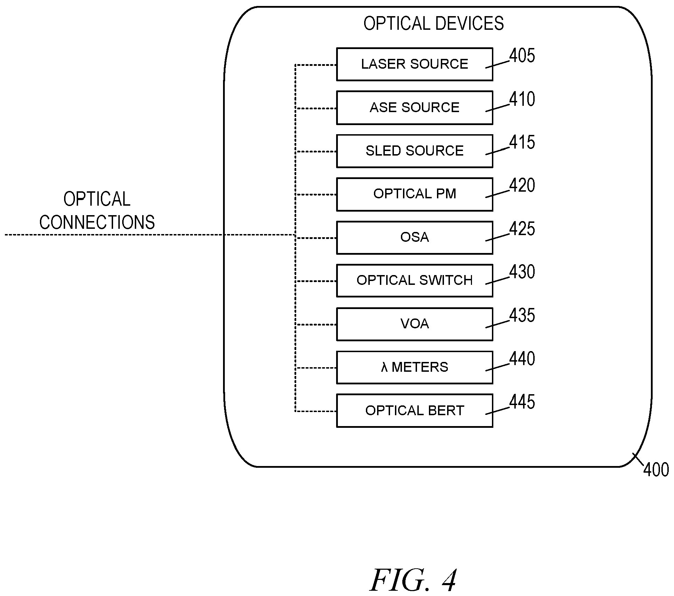

FIG. 4 shows optical devices 400 (e.g., optical test device 330 or light source 333) that can interface with the optical-electrical DUT 120 using optical connections, according to some example embodiments. In the example illustrated, the optical testing devices include one or more of: the laser source 405, an Amplified Spontaneous Emission (ASE) source 410, a super-luminescent light emitting diode (SLED) source 415, an optical power meter 420, an OSA 425, an optical switch 430, a variable optical attenuator 435, a wavelength meter 440, and an optical bit error rate tester (BERT) 445. In some example embodiments, one or more of the optical devices 400 are integrated into the optical test assembly 130 or as stand alone modules connected to the optical-electrical DUT using optical fibers (e.g., eight single mode fibers, as discussed above).

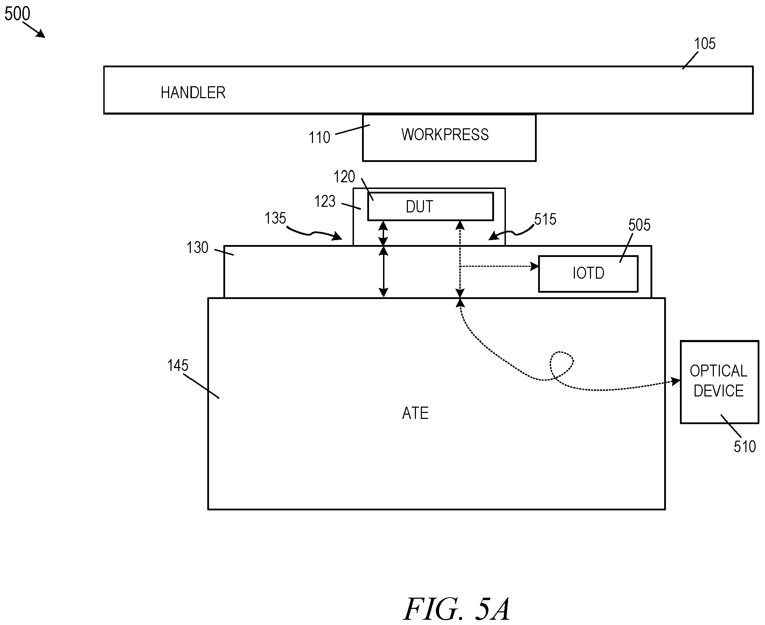

FIG. 5A shows an optical socket interface architecture 500, according to some example embodiments. In the example of FIG. 5A, the DUT 120 includes an optical port (e.g., a grating or a waveguide) on a socket-side of the DUT 120 that interfaces with a top-side of the socket 123. The DUT 120 can emit and receive light via the socket-side port to the optical test assembly 130, which can interface with an optical test device 510 that is external to the ATE 145 (e.g., a standalone optical device). Further, light from the DUT120 can propagate through the socket 123 and the optical test assembly 130 and integrated optical test device 505 that is integrated into the optical test assembly 130. For example, a compact OSA can be mounted on the optical test assembly 130, and by coupling the DUT 120 into the socket 123, optical connections 515 of the socket optical interface are coupled to the compact integrated optical test device 505.

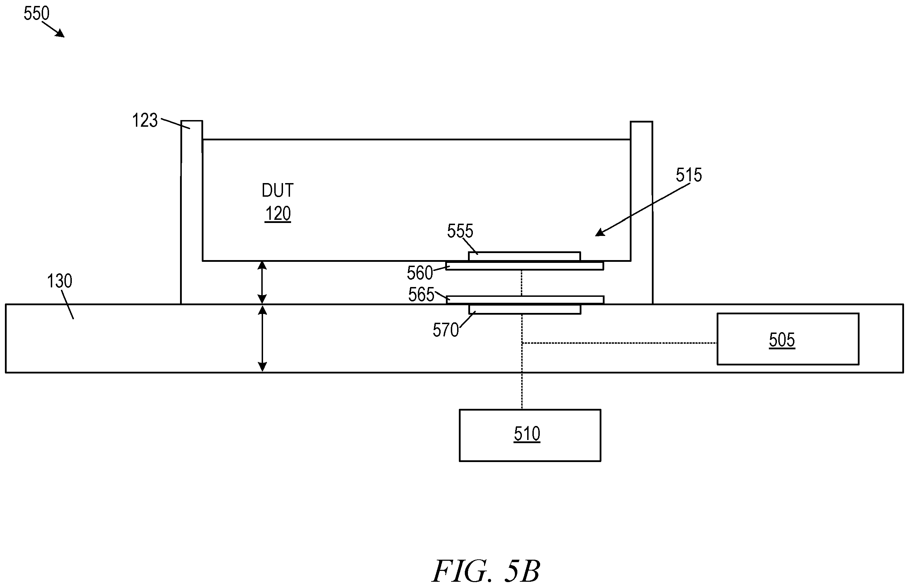

FIG. 5B shows port architecture for the socket-side optical connection 550, according to some example embodiments. As illustrated in FIG. 5B, the DUT 120 includes an optical port 555 that optically couples to a top-side port 560 (e.g., grating of the socket 123). Light received by the top-side port 560 is coupled to a bottom side port 565 of the socket 123 via an internal light path (denoted by the dotted line, e.g., free space or a hole, an integrated fiber or waveguide in the socket 123). The bottom-side port 565 receives light and couples the light to a top-side port 570 (e.g., grating, lens, waveguide, fiber) of the assembly 130, which then inputs or receives the light to or from one or more optical test devices (e.g., compact integrated optical test device 505). In some example embodiments, ports in the socket (e.g., port 560, port 565) are omitted, and the socket 123 includes a hole or cavity (e.g., drilled hole) through which light can propagate from the port 555 to the port 570.

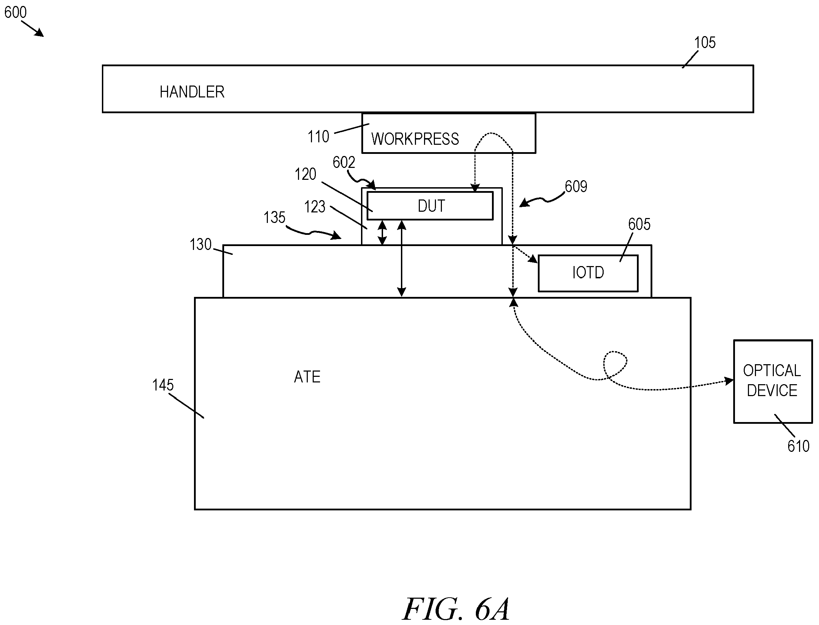

FIG. 6A shows a docking board optical interface optical interface architecture 600, according to some example embodiments. In the example of FIG. 6A, the DUT 120 has an optical port on a top-side 602 the DUT 120. For example, the DUT 120 is a "flip-chip" optical device having electrical connections on a socket facing a side of the DUT 120 and an optical port on a top-side of the DUT that faces away from the socket 123. It is appreciated that in flip-chip architectures, the electrical interface side of a DUT may be referred to as the "top-side" albeit a top-side that faces down to electrically interconnect (e.g., with the socket 123 or an optical interposer), and the "bottom-side" of the flip-chip DUT faces up away from the electrical interconnect side. The DUT 120 can emit or receive light via the top-side 602 to the workpress assembly 110, which then couples the light to the optical test assembly 130 towards an integrated optical test device 605 or the optical test device 610 via an optical pathway 609.

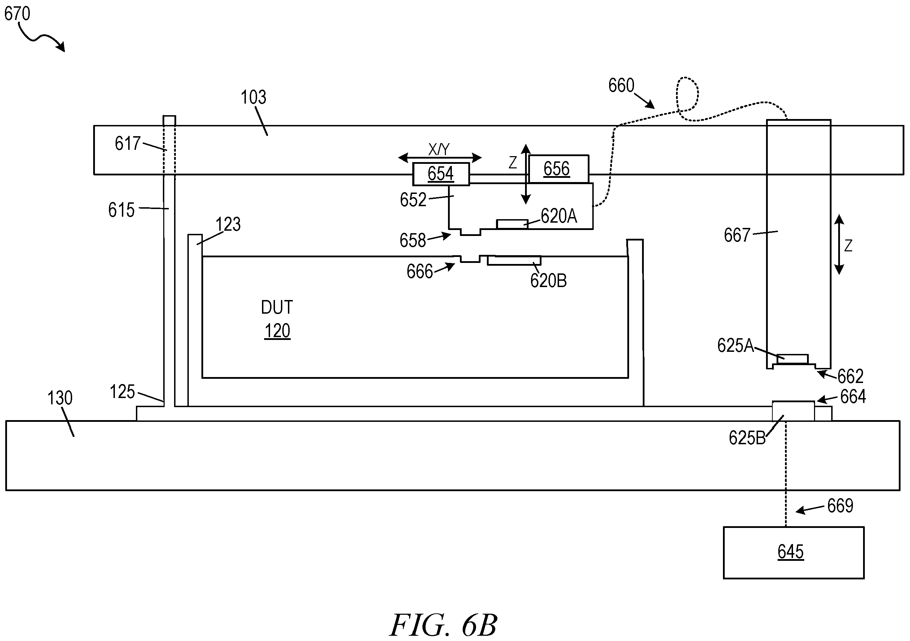

FIG. 6B shows a detailed view 670 of the optical interface architecture, according to some example embodiments. In FIG. 6B, device alignment features include feature 615 of a docking plate 125 attached to the optical test assembly 130. As illustrated, the feature 615 is interlocked with feature 617, which can be a hole in the mount 103 (e.g., a plastic mount attached to the workpress assembly 110, where feature 617 is a hole in the mount through which feature 615 passes for coarse alignment). For further optical alignment, an optical interconnect head 652 is attached to the assembly 110 using adjusters, such as adjusters 654 (e.g., screws) and a spring adjuster 656. The optical interconnect head 652 can receive fiber 660, which is further connected to beam 667 (e.g., a plastic beam that is slidable in the vertical, "Z" direction). In the example of FIG. 6B, the handler 105 (not depicted) moves the assembly 110 until the feature 615 is inserted into feature 617 to complete coarse alignment. Next, fine optical alignment is performed by guiding the assembly 110 (e.g., via the handler 105) until a port 625A on the beam 667 couples to port 625B of the docking plate 125 (e.g., a docking board optical coupler). In some example embodiments, the beam 667 has receiver feature 662 that interlocks with the extruded feature 664 to optically couple the ports 625A and 625B (e.g., free space coupler, butt-couple, grating to lens coupling, etc.). The port 625B can input or receive light into or from optical device 645 (e.g., one or more of optical devices 400) via fiber 669 (e.g., eight fibers of a ribbon).

Further, the optical interconnect head 652 is actuated by the handler 105 (e.g., via robotic arm actuation) until a fine optical alignment feature 658 (e.g., grooved fine alignment feature) snaps into a corresponding feature 666 on the DUT 120. In some example embodiments, the DUT 120 does not include alignment features and instead a receptacle is placed on the DUT and the receptable includes the feature 666 into which the feature 658 interlocks. The features 658, 666, are physically smaller than the coarse features to ensure precise passive optical coupling between optical ports, including port 620A, port 620B, port 625A, and port 625B, without performing active alignment (e.g., using a light source to optically align the ports). For instance, the features 658 and 666 can be fabricated to be on the same scale as the ports 620A and 620B to ensure that once the features 658 and 666 interlocked, the ports 620A and 620B are precisely optically coupled. Further, the features 662 and 664 are fabricated on a same or similar scale as the ports 625A and 625B to ensure that once the beam 667 interlocks with the docking plate 125 (via interconnection of features 662 and 664), the ports 625A and 625B are also optically aligned and coupled without using active alignment.

In some example embodiments, the optical interconnect head 652 is configured as an optical blind mate-able connector that precisely snaps into place with the spring adjuster 656 providing tension in the vertical "Z" direction and X/Y positioning using the adjusters 654, which can be screws to move the head 652 for X/Y alignment. For example, the head 652 floats in three dimensions (X, Y, and Z), and the adjusters 654 can be adjusted manually to first adjust the X and Y alignment, followed by lowering the mount and the optical interconnect head 652 until tension provided by the spring adjuster 656 snaps the fine optical alignment features 658 and 666 into aligned and locking position. In some example embodiments, the head 652 floats in three dimensions on springs without the mechanical adjusters. For example, the adjusters 654 can be implemented as springs to provide tension in the X dimension, Y dimension, or both. In these example embodiments, the head 652 snaps into passive alignment via the tension such that the fine alignment features interlock, thereby passively aligning the optical device interface. Further details of the optical interconnection head 652 are discussed in Application titled "Multi-Lane Optical-Electrical Device Testing Using Automated Testing Equipment," filed on even date herewith, which are incorporated by reference in their entirety.

In some example embodiments, the port 620A and 620B are aligned using actively aligned optics with the adjusters 654 and 656. For example, light from the fiber 660 is provided to the port 620A and coupled to 620B for optimal coupling. In some example embodiments, the amount of light coupled to the port 620B is measured by a photodetector in the DUT 120 and maximized in the active alignment process. In other example embodiments, the light received at the port 620B propagates through the DUT 120 (e.g., via an optical loopback path) and is coupled back to the port 620A for measurement (e.g., by a photodetector in the optical device 645).

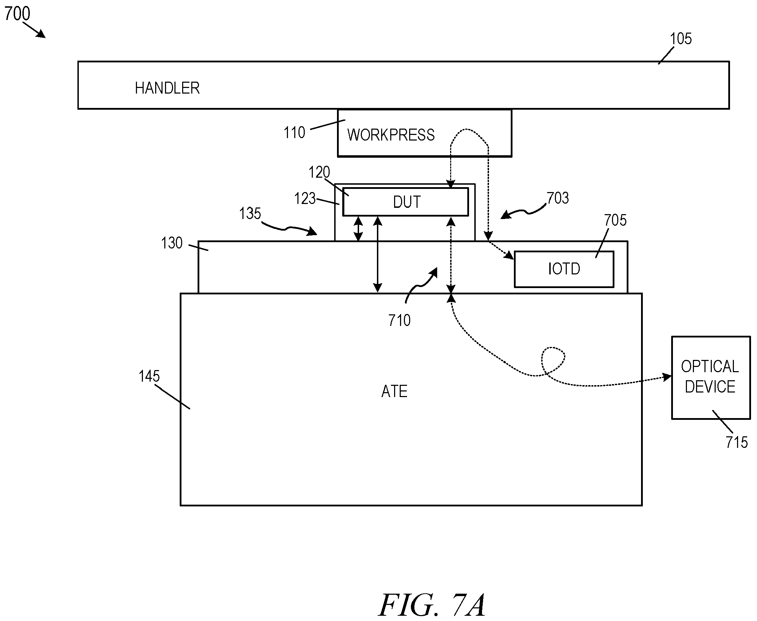

FIG. 7A shows a mount and socket based optical interface architecture 700, according to some example embodiments. In the example of FIG. 7A, the DUT 120 has an optical port on the socket-facing side that couples light to the socket 123 and to the optical test assembly 130. For example, a bottom facing grating of the DUT 120 emits light through a hole in the socket 123 to an optical port of the optical test assembly 130, which is then coupled into an optical test device 715 by optical connections 710 (via a fiber coupled to the optical port), as discussed with above with reference to FIG. 5A and 5B.

Further, the DUT 120 in architecture 700 has an additional optical port to transmit and receive light on a top-side of the DUT 120 (e.g., side facing away from the electrical interface side coupled to the socket 123). The light from the topside of the DUT 120 can be optically coupled to a mount based optical connection 703 to integrated optical device 705 in the optical test assembly 130, as discussed above with reference to FIG. 6A and 6B, according to some example embodiments.

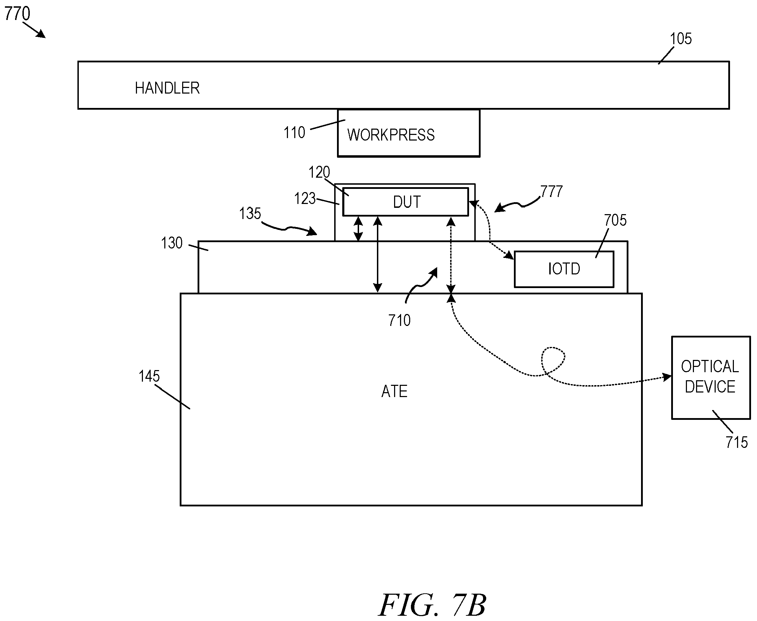

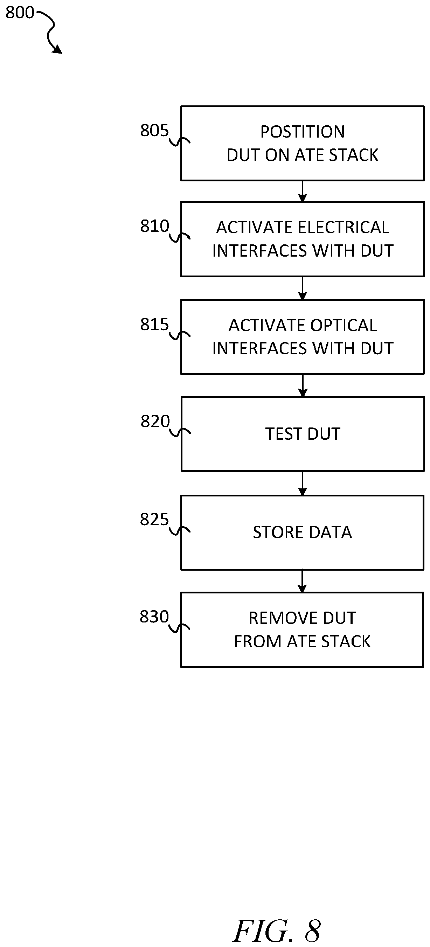

FIG. 7B shows side socket based optical interface architecture 770, according to some example embodiments. In the example of FIG. 7B, the DUT 120 are coupled to the optical device 705 via side optical connections 777. For example, the beam 667 includes the optical interconnect head 652 on the side to blinded mate to a side port of the optical device under test 120 (e.g., via screw adjusters and/or a spring adjuster). FIG. 8 is a flow diagram of a method 800 for optical-electrical testing, according to some example embodiments. At operation 805, the DUT is positioned on an ATE stack. For example, with reference to FIG. 1, the handler 105 attaches to the DUT 120 and moves the DUT to the hybrid test stack 180 (e.g., to the socket 123). In positioning the DUT 120 on the hybrid test stack 180, the optical and electrical interfaces are connected such that optical test devices are optically coupled to the DUT 120 and electrical test devices are electrically connected to the DUT 120.

At operation 810, the electrical interface is activated. For example, a microprocessor on the DUT or external computer executes calibration instructions to cause the DUT to send and receive data to electrical testing devices. At operation 815, the optical interface of the DUT is activated to send and receive data from optical test devices. At operation 820, the DUT is calibrated using the electrical and optical interfaces as discussed above with reference to FIG. 3. At operation 825, calibration data is stored (e.g., optical component settings of the DUT are stored). At operation 830, the DUT is removed from the stack. For example, the handler 105 moves the DUT 120 from the socket 123 to a good DUT stack (DUTs that passed calibration and testing) or a bad DUT stack (e.g., DUTs that failed calibration or testing).

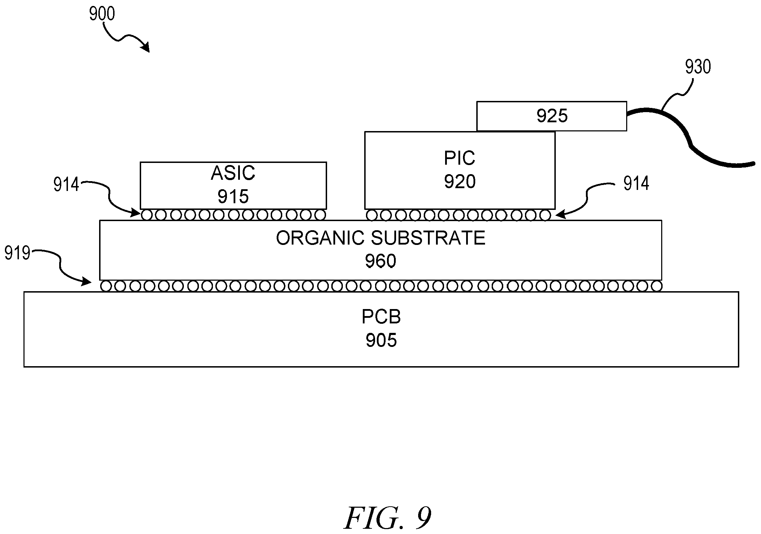

FIG. 9 is an illustration of an optical-electrical device 900 (e.g., optical-electrical DUT 120, optical transceiver 200) including one or more optical devices, according to an embodiment of the disclosure. In this embodiment, the optical-electrical device 900 is a multi-structure chip package that includes a printed circuit board (PCB) substrate 905, organic substrate 960, application specific integrated circuit 915 (ASIC), and PIC 920. In this embodiment, the PIC 920 may include one or more optical structures described above (e.g., PIC 210).

In some example embodiments, the PIC 920 includes silicon on insulator (SOI) or silicon-based (e.g., silicon nitride (SiN)) devices, or may comprise devices formed from both silicon and a non-silicon material. Said non-silicon material (alternatively referred to as "heterogeneous material") may comprise one of III-V material, magnetooptic (MO) material, or crystal substrate material. III-V semiconductors have elements that are found in group III and group V of the periodic table (e.g., Indium Gallium Arsenide Phosphide (InGaAsP), Gallium Indium Arsenide Nitride (GalnAsN)). The carrier dispersion effects of III-V-based materials may be significantly higher than in silicon-based materials, as electron speed in III-V semiconductors is much faster than that in silicon. In addition, III-V materials have a direct bandgap, which enables efficient creation of light from electrical pumping. Thus, III-V semiconductor materials enable photonic operations with an increased efficiency over silicon for both generating light and modulating the refractive index of light. Thus, III-V semiconductor materials enable photonic operation with an increased efficiency at generating light from electricity and converting light back into electricity.

The low optical loss and high quality oxides of silicon are thus combined with the electro-optic efficiency of III-V semiconductors in the heterogeneous optical devices described below; in embodiments of the disclosure, said heterogeneous devices utilize low loss heterogeneous optical waveguide transitions between the devices' heterogeneous and silicon-only waveguides.

MO materials allow heterogeneous PICs to operate based on the MO effect. Such devices may utilize the Faraday Effect, in which the magnetic field associated with an electrical signal modulates an optical beam, offering high bandwidth modulation, and rotates the electric field of the optical mode, thereby enabling optical isolators. Said MO materials may comprise, for example, materials such as iron, cobalt, or yttrium iron garnet (YIG). Further, in some example embodiments, crystal substrate materials provide heterogeneous PICs with a high electro-mechanical coupling, linear electro optic coefficient, low transmission loss, and stable physical and chemical properties. Said crystal substrate materials may comprise, for example, lithium niobate (LiNbO3) or lithium tantalate (LiTaO3). In the example illustrated, the PIC 920 exchanges light with fiber 930 via prism 925; said prism 925 is a misalignment-tolerant device used to couple an optical mode to one or more single-mode optical fibers (e.g., to transmit light to and from an optical network), according to some example embodiments.

In some example embodiments, the optical devices of PIC 920 are controlled, at least in part, by control circuitry included in ASIC 915. Both ASIC 915 and PIC 920 are shown to be disposed on copper pillars 914, which are used for communicatively coupling the ICs via organic substrate 960. PCB 905 is coupled to organic substrate 960 via ball grid array (BGA) interconnect 919, and may be used to interconnect the organic substrate 960 (and thus, ASIC 915 and PIC 920) to other components of optical-electrical device 900 (not shown), such as interconnection modules, power supplies, and so forth.

The following are example embodiments:
Example 1. An automated testing equipment (ATE) system for testing of an optical-electrical device under test (DUT) comprising: an actuating mount to position the optical-electrical DUT on a first side of a socket having electrical connections for the optical-electrical DUT; a docking board in contact with a second side of the socket, the docking board comprising an electrical interface to receive one or more electrical signals from the optical-electrical DUT via the electrical connections of the socket, the first side and second side being opposite sides of the socket, the docking board further comprising a docking board optical interface; an electrical test device to analyze one or more electrical signals from the optical-electrical DUT, the one or more electrical signals received from the electrical paths of the socket and the electrical interface of the docking board; and an optical test device to analyze one or more optical signals from the optical-electrical DUT, the one or more optical signals received by the optical test device from the optical-electrical DUT via propagation through the docking board optical interface such that the one or more optical signals being analyzed by the optical test device of the ATE system while the one or more electrical signals are analyzed by the electrical test device of the ATE system.
Example 2. The ATE system of example 1, wherein the docking board optical interface is optically coupled to the optical-electrical DUT by a docking board optical coupler included in the docking board optical interface.
Example 3. The ATE system of any of examples 1 or 2, wherein the docking board optical coupler comprises one or more of: a grating, a fiber, a lens.
Example 4. The ATE system of any of examples 1-3, wherein the optical coupler is a fiber that passes through a hole in the docking board to the optical testing device.
Example 5. The ATE system of any of examples 1-4, wherein the socket comprise a socket optical interface to the optical-electrical DUT.
Example 6. The ATE system of any of examples 1-5, wherein the socket optical interface comprises a grating, a fiber, a lens.
Example 7. The ATE system of any of examples 1-6, wherein the docking board includes passive alignment features that interlock with corresponding passive alignment features of the actuating mount to passively optical couple the docking board to the actuating mount.
Example 8. The ATE system of any of examples 1-7, wherein the optical-electrical DUT includes alignment features that interlock with corresponding passive alignment features of the actuating mount.
Example 9. The ATE system of any of examples 1-8, wherein the actuating mount is attached to a robotic arm that moves to releasably pick-up the optical-electrical DUT from a staging area and place the optical-electrical DUT on the socket to optical and electrical testing using the ATE system.
Example 10. The ATE system of any of examples 1-9, wherein the optical testing device is an optical spectrum analyzer.
Example 11. The ATE system of any of examples 1-10, wherein the electrical testing device is a bit error rate tester.
Example 12. A method testing of an optical-electrical device under test (DUT) using an automated testing equipment (ATE) system, comprising: positioning, using an actuating mount, an optical-electrical DUT on a first side of a socket having electrical connections for the optical-electrical DUT, a second side of the socket that is opposite of the first side being attached to a docking board that comprises an electrical interface to receive one or more electrical signals from optical-electrical DUT via the electrical connections of the socket, the docking board further comprising a docking board optical interface to optically couple with the optical-electrical DUT; electrically testing, using an electrical test device of the ATE system, the optical-electrical DUT by analyzing one or more electrical signals from the optical-electrical DUT received from the electrical paths of the socket and the electrical interface of the docking board; optically testing, using an optical test device of the ATE system, the optical-electrical DUT while the analyzing the one or more signals using the electrical test device, the optical-electrical DUT optically tested by analyzing one or more optical signals received by the optical test device from the optical-electrical DUT via propagation through the docking board optical interface.
Example 13. The method of any of example 12, wherein the docking board optical interface is optically coupled to the optical-electrical DUT by a docking board optical coupler included the docking board optical interface.
Example 14. The method of any of examples 12 or 13, wherein the socket comprise a socket optical interface to the optical-electrical DUT.
Example 15. The method of any of examples 12-14, wherein the docking board includes passive alignment features that interlock with corresponding passive alignment features of the actuating mount to passively optical couple the docking board to the actuating mount.
Example 16. The method of any of examples 12-15, wherein the optical-electrical DUT includes passive alignment features that interlock with corresponding passive alignment features of the actuating mount to passively optical couple the docking board to the actuating mount.
Example 17. The method of any of examples 12-16, wherein the actuating mount is attached to a robotic arm that moves to releasably pick-up the optical-electrical DUT from a staging area and place the optical-electrical DUT on the socket to optical and electrical testing using the ATE system.
Example 18. The method of any of examples 12-17, wherein the optical testing device is an optical spectrum analyzer.
Example 19. The method of any of examples 12-18, wherein the electrical testing device is a bit error rate tester.
Example 20. The method of any of examples 12-19, wherein the optical-electrical DUT is an optical transceiver.

In the foregoing detailed description, the method and apparatus of the present inventive subject matter have been described with reference to specific example embodiments thereof. It will, however, be evident that various modifications and changes may be made thereto without departing from the scope of the claims. The present specification and figures are accordingly to be regarded as illustrative rather than restrictive.

Thus, from one perspective, there has now been described a hybrid optical-electrical automated testing equipment (ATE) system that can implement an optical test assembly that includes an electrical interface and an optical interface with an optical-electrical device under test. The optical assembly can include a socket on which the device is placed by the ATE system to connect electrical and optical connections. The optical connections can couple light through the socket and the optical assembly to one or more testing devices to perform efficient testing of optical devices, such as high-speed optical transceivers.

## Claims

1. An automated testing equipment (ATE) system for testing of an optical-electrical device under test (DUT), the system comprising:
an actuating mount configured to position an optical-electrical DUT on a first side of a socket having electrical connections for the optical-electrical DUT;
a docking board in contact with a second side of the socket, the docking board comprising an electrical interface for receiving one or more electrical signals from the optical-electrical DUT via the electrical connections of the socket, the first side and second side being opposite sides of the socket, the docking board further comprising a docking board optical interface;
an electrical test device configured to analyze one or more electrical signals from the optical-electrical DUT, the one or more electrical signals received from the electrical paths of the socket and the electrical interface of the docking board; and
an optical test device configured to analyze one or more optical signals from the optical-electrical DUT, the one or more optical signals received by the optical test device from the optical-electrical DUT via propagation through the docking board optical interface such that the one or more optical signals being analyzed by the optical test device of the ATE system while the one or more electrical signals are analyzed by the electrical test device of the ATE system.

2. The ATE system of claim 1, wherein the docking board optical interface is optically coupled to the optical-electrical DUT by a docking board optical pathway included in the docking board optical interface.

3. The ATE system of claim 2, wherein the docking board optical coupler comprises one or more of: a grating, a lens, and a fiber that passes through a hole in the docking board to the optical testing device.

4. The ATE system of any preceding claim, wherein the socket comprises a socket optical interface to the optical-electrical DUT, the socket optical interface comprising one or more of: a grating, a fiber, and a lens.

5. The ATE system of any preceding claim, wherein the docking board includes passive alignment features that interlock with corresponding passive alignment features of the actuating mount to passively optical couple the docking board to the actuating mount.

6. The ATE system of any preceding claim, wherein the actuating mount is attached to a robotic arm that moves to releasably pick-up the optical-electrical DUT from a staging area and place the optical-electrical DUT on the socket to optical and electrical testing using the ATE system.

7. The ATE system of any preceding claim, wherein the optical testing device includes one or more of: an external light source to transmit light to an optical receiver of the optical-electrical DUT, an optical spectrum analyzer to analyze light received from an optical transmitter of the optical-electrical DUT.

8. The ATE system of any preceding claim, wherein the electrical testing device is a bit error rate tester.

9. A method testing of an optical-electrical device under test (DUT) using an automated testing equipment (ATE) system, the method comprising:
positioning, using an actuating mount, an optical-electrical DUT on a first side of a socket having electrical connections for the optical-electrical DUT, a second side of the socket that is opposite of the first side being attached to a docking board that comprises an electrical interface to receive one or more electrical signals from optical-electrical DUT via the electrical connections of the socket, the docking board further comprising a docking board optical interface to optically couple with the optical-electrical DUT;
electrically testing, using an electrical test device of the ATE system, the optical-electrical DUT by analyzing one or more electrical signals from the optical-electrical DUT received from the electrical paths of the socket and the electrical interface of the docking board;
optically testing, using an optical test device of the ATE system, the optical-electrical DUT while the analyzing the one or more signals using the electrical test device, the optical-electrical DUT optically tested by analyzing one or more optical signals received by the optical test device from the optical-electrical DUT via propagation through the docking board optical interface.

10. The method of claim 9, wherein the docking board optical interface is optically coupled to the optical-electrical DUT by a docking board optical coupler included the docking board optical interface.

11. The method of claim 9 or claim 10, wherein the socket comprises a socket optical interface to the optical-electrical DUT.

12. The method of any of claims 9 to 11, wherein the docking board includes passive alignment features that interlock with corresponding passive alignment features of the actuating mount to passively optical couple the docking board to the actuating mount.

13. The method of any of claims 9 to 12, wherein the actuating mount is attached to a robotic arm that moves to releasably pick-up the optical-electrical DUT from a staging area and place the optical-electrical DUT on the socket to optical and electrical testing using the ATE system.

14. The method of any of claims 9 to 13, wherein the optical testing device includes one or more of: an external light source to transmit light to an optical receiver of the optical-electrical DUT, an optical spectrum analyzer to analyze light received from an optical transmitter of the optical-electrical DUT.

15. The method of any of claims 9 to 14, wherein the electrical testing device is a bit error rate tester.
